# EUROPEAN PATENT SPECIFICATION

(11) **EP 0 752 594 B1**
(45) Date of publication and mention of the grant of the patent: **17.05.2000**
(21) Application number: 96109960.3
(22) Date of filing: 20.06.1996
(51) Int. Cl.: G01R 31/316, G01R 1/073, H01L 21/66

(54) **Contact structure for electrically connecting a testing board and die**
Kontaktstruktur für die elektrische Verbindung von Testplatine und Chip
Structure de contacts de connexion électrique d'une plaque de test à une puce

(30) Priority: 03.07.1995 US 497315
(43) Date of publication of application: 08.01.1997
(73) Proprietor: MOTOROLA, INC., Schaumburg, IL 60196 (US)
(72) Inventor: Stafford, John W., Phoenix, Arizona 85048 (US); Vasquez, Barbara, 112 Austin, Texas 78746 (US); Williams, William M., Gilbert, Arizona 85234 (US)
(74) Representative: Gibson, Sarah Jane

(56) References cited:
- EP-A- 0 632 281
- GB-A- 2 247 565
- US-A- 4 975 079
- PATENT ABSTRACTS OF JAPAN vol. 095, no. 004, 31 May 1995 & JP 07 012892 A (NEC CORP), 17 January 1995,

## Description

### Background of the Invention

The present invention relates, in general, to testing of semiconductor devices and, more particularly, to a contact structure for a die-level or wafer-level testing board.

After their manufacture, integrated circuits (ICs) are subjected to various types of testing to verify their reliability and operability. This testing may include functional testing and exposure of the IC to high and/or low temperature extremes. One type of testing done at a high temperature is known as burn-in testing and involves the application of an electrical bias or other signals to the IC during an elevated-temperature baking period. The purpose of such burn-in testing is to accelerate the appearance of any latent defects which might otherwise only show up after many hours of IC use.

In the past, burn-in testing often has been performed on ICs that have already been placed into a final package. However, the trend in burn-in testing is to perform such testing at the semiconductor wafer level. This can be done by either testing of IC dies prior to their separation from a processed wafer or testing of individual IC dies after separation from the wafer, but prior to packaging. One advantage of such testing is a reduction in the cost of the testing due to the elimination of interposers or other intermediate contact assemblies that have been required in the past to connect a burn-in testing circuit to the ICs on the wafer. Another advantage of wafer-level testing is the ability to more quickly provide feedback to the wafer fabrication line based on the results of functional and burn-in testing at the end of the line.

When testing an IC on, for example, a so-called flip-chip die, a testing board is used that has many contacts for electrically connecting test-signal layers in the board to solder bumps on the die. Previously, the tops of these contacts typically had flat surfaces for making contact to the bumps. A problem with such flat surfaces is the difficulty of aligning the bumps with the contacts and the need to provide excessive force on the bumps during contact to provide good electrical continuity, in part, by breaking through the thin oxide layer on the surfaces of the bumps. This excessive force often deforms the solder bumps to an extent that requires an additional manufacturing step of reflowing the bumps to remove the deformation.

Another problem with prior testing boards using flat-surface contacts is the difficulty in achieving good planarity of both the testing board and the semiconductor wafer and good parallelism between the testing board and the wafer during testing contact. Because it is desirable for the testing board to make contact to a large number of integrated circuits on a wafer, it is important that the board and wafer remain both substantially planar and parallel during the varying hot and cold temperatures used during testing. If good planarity and parallelism are not maintained, then many ICs on the wafer will not be properly tested due to poor electrical connections between the solder bumps and the contacts on the testing board. A weakness of the prior flat-surface contact is the lack of compensation for testing board and wafer non-planarity and/or non-parallelism due to limits on deformation of the solder bumps during testing contact.

To overcome some of these problems, US-A- 4 975 079 suggests a testing board in accordance with the preamble of claim 1.

Accordingly, there is a need for an improved contact structure and method for a testing board that aids in maintaining the alignment of conductive bumps, such as solder bumps, and contacts during testing, provides good electrical contact with minimum deformation of the bumps, and reduces the adverse effects of testing board and wafer non-planarity or non-parallelism.

The invention provides a testing board as defined in claim 1, a method of testing as defined in claim 5 and a method of providing an electrical connection as defined in claim 8.

### Brief Description of the Drawings

FIG. 1 is a cross-sectional side view of a contact structure having an annular contact disposed on a testing board according to the present invention;
FIGs. 2 and 3 are cross-sectional side views illustrating a testing board contact method using a swage limit according to another embodiment of the present invention; and
FIG. 4 is a cross-sectional side view of a contact structure having an annular contact disposed on a die according to a further embodiment of the present invention.

### Detailed Description of the Drawings

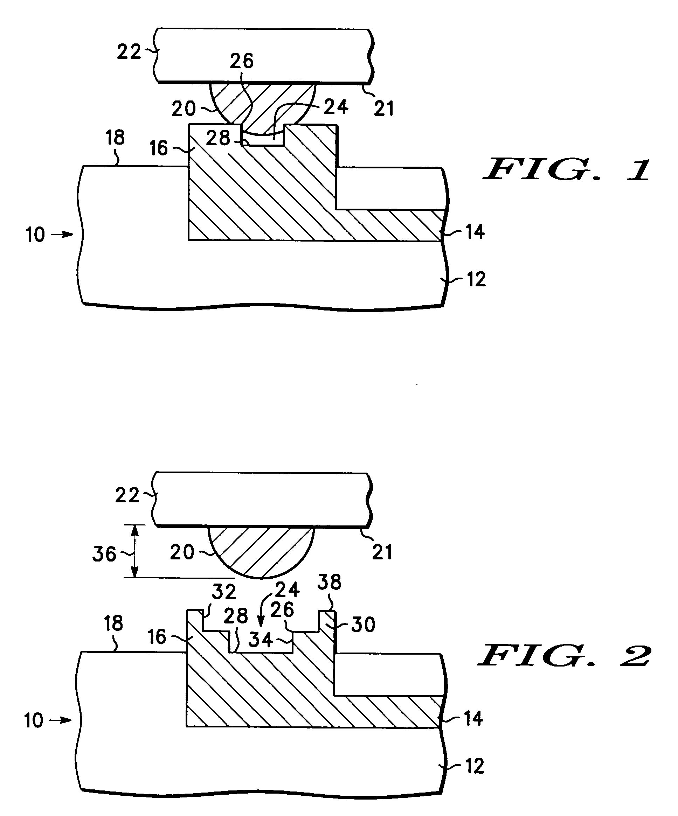

FIG. 1 is a cross-sectional side view of a testing board 10 comprising a substrate 12 having a top surface 18 and a signal layer 14 disposed in substrate 12. An annular contact 16 protrudes from top surface 18 and comprises an opening 24 having an edge 26 and a bottom surface 28. Annular contact 16 is preferably substantially circular in shape, but one of skill in the art will recognize that other shapes such as rectangular may be used.

According to the present invention, opening 24 of annular contact 16 is provided to accommodate a deformable conductive bump 20, which is disposed on a surface 21 of a die 22. Typically, die 22 contains an IC, and conductive bump 20 is, for example, a solder bump (which is typically round) as used with a conventional flip-chip die. Although the specific example of a solder bump is described herein, one of skill in the art will recognize that other appropriate materials, including non-lead solders such as indium or conductive polymers, can be used to form bump 20. Die 22 can be either singulated or one of a plurality of dies joined together on a common semiconductor wafer (not shown).

Testing board 10 has a conventional, multiple-layer structure and is preferably formed from a flouoropolymer for low cost and good planarity. However, other materials including ceramics and organics (such as polyimide) can be used. Testing board 10 and annular contact 16 can both be manufactured using well-known techniques used for forming printed wire boards. In a preferred embodiment, testing board 10 has a plurality of annular contacts 16 disposed on top surface 18, and die 22 has a plurality of conductive bumps 20 to be contacted by contacts 16.

According to a method of the present invention, bump 20 is substantially aligned with the center of opening 24 prior to physical contact. Then, a contacting force is applied to press die 22 and substrate 12 together so that bump 20 is swaged into opening 24 and at least slightly deformed at edge 26. The alignment of bump 20 to contact 16 requires less precision than with prior contacts because opening 24 tends to self-align with bump 20 prior to and during the initial deformation of the bump when it is being swaged. As a result of this self-alignment, precision assembly equipment, which typically includes vision alignment systems, can be simplified or eliminated. In addition, manual alignment will sometimes be possible because an operator can sense the point at which bumps 20 and openings 24 are substantially aligned. The result of the above swaging is that die 22 is mechanically locked onto and electrically connected to testing board 10 at contact 16.

The degree to which bump 20 is swaged by annular contact 16 is determined by the magnitude of the contacting force used, and it should be noted that the swaging does not require any lateral or rotary motion. Preferably, the contact force has a magnitude sufficiently small so that bump 20 is not deformed beyond the limit suitable for subsequent assembly. For example, if solder bumps are used, the force is sufficiently small that the bumps need not be reflowed to restore their shape following testing by testing board 10.

However, when desired, a greater contact force can be used so that bump 20 is swaged to a significant extent into opening 24. If the bump is deformed past the limit suitable for subsequent assembly, it can be re-shaped. For example, with solder bumps this re-shaping can be done by well-known reflowing techniques. Also, it is not necessary that bump 20 contact bottom surface 28 after being swaged, though this can be done if desired. Conventional testing is performed after bump 20 has been swaged.

In order to accomplish the swaging of the present invention, it is preferable that opening 24 have a diameter less than the diameter of bump 20. A typical diameter for opening 24 when conventional solder bumps are used is about 50 microns. In addition, it is preferable that annular contact 16 be formed of a material that is harder than that used to form bump 20. As a specific, non-limiting example, it is preferable that contact 16 have a modulus of elasticity greater than about 105 kg/m² and that bump 20 have a modulus of elasticity less than about 28 kg/m². Also, contact 16 preferably has a yield strength at least about four times greater than that of bump 20. Contact 16 can, for example, be formed of copper or aluminum and can be optionally plated with a metal layer such as rhodium, palladium, platinum, or a nickel/gold alloy. Bump 20 can be a conventional solder bump made from materials such as 95% lead/5% tin, a eutectic solder of 40% lead/60% tin, or other solder materials conventionally used for flip-chip on board (FCOB) and direct chip attach (DCA).

An advantage of the present invention is that the swaging of bump 20 into contact 16 provides a frictional fit of bump 20 such that die 22 remains substantially fixed in place during testing. The magnitude of the frictional force providing this fit varies depending upon the materials used to form bump 20 and contact 16. Specifically, it has been found that if contact 16 is plated with palladium, a solder bump 20 is held with a relatively small frictional force. In contrast, if contact 16 is plated with an alloy of nickel and gold, bump 20 is held in place by a larger frictional force. The frictional fitting force will also vary depending on the degree of swaging and the dimensions of opening 24 relative to bump 20. Further, the range of acceptable frictional force depends on the number of contacts formed per die (or per wafer if the dies are not singulated) for testing. The frictional force should be sufficiently high so the die (or wafer) remains substantially fixed in place during testing, but sufficiently low so the die (or wafer) can be removed from the test board without unacceptable damage to bumps 20.

Another advantage of the present invention is that edge 26 of contact 16 deforms the surface of bump 20 sufficiently to break through any native oxide layer that is present on the electrically conductive material of bump 20. This ensures a good, uniform electrical contact to all of the typically large number of bumps 20 spread across die 22.

A further advantage of the present invention observed when swaging a large number of conductive bumps 20 into a like number of annular contacts 16 is an improvement in the compliance of the contact between bumps 20 and contact 16 for the full surface extent of die 22. This additional compliance results in part from the differing degrees of swaging that can occur in each contact 16 across the surface of testing board 10. In other words, by providing a nominal clearance between bump 20 and bottom surface 28, bumps 20 can be swaged to differing degrees depending on the variance of die 22 or testing board 10 from the desired planar or parallel condition.

As a specific example for the case where many bumps 20 are to be contacted, if surface 21 in a first region of die 22 is a relatively large distance from surface 18 of testing board 10 due to non-planarity, it will be swaged to a relatively small extent. However, if surface 21 in a second region of die 22 is a relatively small distance from surface 18, it will be swaged to a relatively large extent. These differing degrees of swaging of bumps 20 provide compliance for non-planarity and/or non-parallelism. Additional compliance can result from the use of a fluoropolymer for testing board 10 because the fluoropolymer itself can be compressed to differing degrees as needed to accommodate non-planarity during the swaging process.

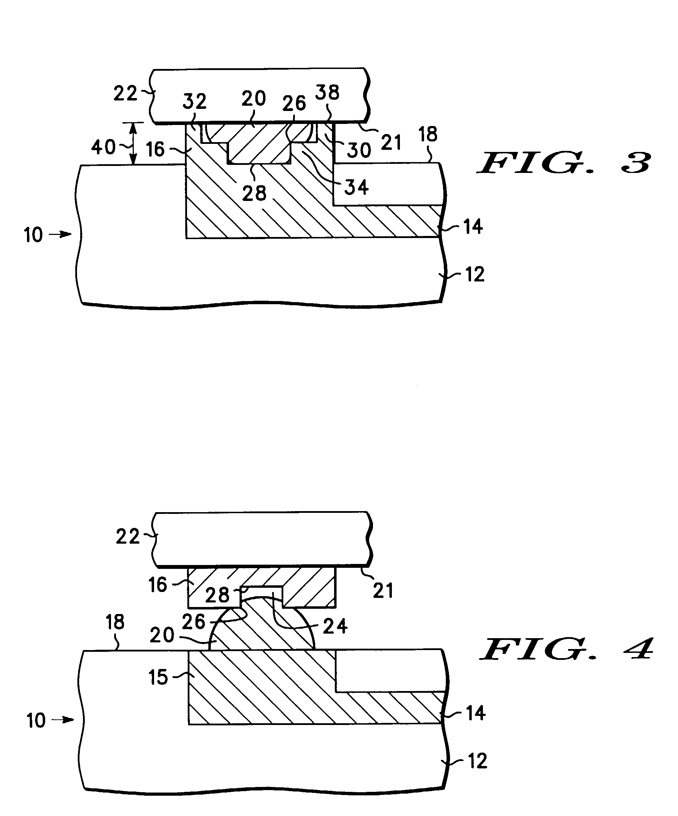

FIGs. 2 and 3 are cross-sectional side views illustrating an annular contact structure and method according to another embodiment of the present invention for an ideal case of perfect center-on-center alignment. Common reference numerals are used for similar elements. FIG. 2 illustrates a swage limit 30 protruding from annular contact 16. Swage limit 30 is used to limit the extent that bump 20 is swaged into opening 24 and can be manufactured using conventional techniques as discussed above for the prior embodiment. A first portion 32 of contact 16, which includes limit 30, has an inner diameter greater than the inner diameter of a second portion 34 so that contact 16 has edge 26 as described above for the prior embodiment.

It should be noted for the case of perfect center-on-center alignment that if the inner diameter of first portion 32 is not greater than the maximum outside diameter of bump 20, then contact 16 can cause substantial deformation to the bulk of bump 20. Such deformation is not desirable due to the adverse effect of bump damage in subsequent assembly. Also, it is desirable in some cases to provide additional tolerance for swage limit 30 to allow for slight misalignment between bump 20 and contact 16.

Annular contact 16 in this embodiment is used substantially as already described above. In particular, a top surface 38 of swage limit 30 stops any swaging by opening 24 when it contacts die 22. Thus, the extent of swaging is primarily determined by the dimensions of swage limit 30 rather than the contact force used as for the prior embodiment described above.

FIG. 3 illustrates bump 20 after it has been swaged into contact 16 according to the present invention. It should be noted that edge 26 preferably deforms bump 20 sufficiently to break through any native oxide layer. Also, in this particular illustration, bump 20 is substantially in contact with bottom surface 28. In other embodiments, however, such contact is not necessary, and a separation here might be preferable. In FIG. 3, top surface 38 is shown in contact with die 22.

As mentioned above, the dimensions of swage limit 30 partly determine the degree of swaging. It is preferable that a swage limit height 40 be substantially equal to a conductive bump height 36 (see FIG. 2) of bump 20. This is preferable in order to provide a uniform and predictable final bump height for bumps swaged during test and burn-in operations, on bumps that are reflowed, or on bumps that are not swaged. A uniform bump height is desirable for reliable assembly of bumped die to circuit boards. Final assembly typically includes underfill operations needing consistently uniform gap heights of the die off of the circuit board surfaces for proper fluid flow. In addition, because semiconductor photolithography processes may be used to create contacts 16 and swage limits 30, the precision and repeatability of swage limit height 40 is often more readily achieved than for the original heights of bumps 20, depending on the bumping process used. Swage limit 30 also prevents excessive swaging, which could occur if a high contact force is applied to bump 20 and contact 16.

FIG. 4 is a cross-sectional side view of a contact structure according to a further embodiment of the present invention. FIG. 4 is similar in structure and method of use to the contact structure of FIG. 1 except that bump 20 is now disposed on a contact base 15 of testing board 10, and annular contact 16 is disposed on surface 21 of die 22. Common reference numerals are used from FIG. 1 for similar elements. Again, annular contact 16 and testing board 10 of this embodiment are formed using conventional techniques. Also, optional swage limit 30 can be used in this embodiment.

This embodiment has the advantage that less care is required to avoid deformation of bumps 20 because they are now not used in the final assembly of the integrated circuit on die 22. After typically one or more uses, bumps 20, which are formed of solder, conductive polymers, or other appropriate materials, are re-shaped to re-establish their original shape. For final assembly, annular contacts 16 are flip-chip assembled to bumps on a single-chip package, a multiple-chip package, or directly on pads formed from solder or a conductive polymer on a circuit board. For the case of flip-chip assembly, the material used for annular contacts 16 should be compatible with and provide reliable, low-resistance contacts to the material forming the bumps used for final assembly. Another advantage is that the use of annular contact 16, if made of a material that can be wetted by solder, reduces the cost of final assembly.

By now, it should be appreciated that there has been provided a novel structure and method of contacting an electronic device disposed on a die using a testing board. Testing board 10 of the present invention provides an improved contact structure compared to the flat-surface contact used in prior testing boards and includes the advantages of self-alignment of bumps 20 and openings 24, good electrical contact to bumps 20 with minimum deformation, and additional tolerance to testing board and semiconductor wafer non-planarity or non-parallelism.

The challenge of obtaining reliable electrical contact between electrically conductive bumps on a die or wafer and the testing board circuitry is achieved by the application of the annular contact structure disclosed herein. As surface oxide layers on the bumps are pushed away during swaging, fresh bump material becomes exposed and is pressed against the test contact metal on the testing board to provide a low-resistance electrical connection. Bump-to-bump local variations and global variations across a single die, a group of several dies, or a whole wafer can be accommodated by the compliance provided by the swaging process of the present invention, only as limited by the height of the contact.

In contrast with prior flat-contact systems, a greater compliance range is obtained because the amount of swaging will vary from bump to bump dependent on original bump size variance, the planarity of the testing board and IC substrate, and the forces applied to swage the bumps. If desired, the amount of swaging can optionally be controlled by the swage height limit feature described above. Additionally, this annular contact structure provides the benefit of a temporary mechanical attachment between the testing board and the die as supported by the frictional force resulting from the swaged bump surface wiping against the annular contact metal.

## Claims

1. A testing board (10) for contacting an electronic device disposed on a die (22), wherein a plurality of conductive bumps (20) are disposed on a surface (21) of said die, comprising:
a substrate (12);
a signal layer (14) supported by said substrate; and
characterised by an annular contact (16) disposed on said substrate and electrically connected to said signal layer, wherein said annular contact has an opening (24) corresponding to one of said plurality of conductive bumps, thus enabling said one conductive bump to be swaged into said opening to contact the edge (26) of said opening.

2. The testing board of claim 1 wherein said annular contact is substantially round and a diameter of said opening corresponds to a diameter of said one of said plurality of conductive bumps and wherein said diameter of said opening is less than said diameter of said one of said plurality of conductive bumps.

3. The testing board of claim 1 wherein said annular contact is plated with at least one material selected from the group consisting of palladium, platinum, or rhodium.

4. The testing board of claim 1 wherein said annular contact further comprises a swage limit (30) having a top surface (38) for contacting said die.

5. A method of testing an electronic device disposed on a die (22), wherein a conductive bump (20) is disposed on said die, comprising the steps of:
providing a testing board (10) having a substrate (12) and an annular contact (16) protruding from a top surface (18) of said substrate wherein said annular contact has an opening (24) corresponding to said conductive bump; and
swaging said conductive bump so that a portion of said conductive bump extends into said opening, contacting the edge of said opening.

6. The method of claim 5 wherein said conductive bump has a modulus of elasticity less than about 28 kg/m² and said annular contact has a modulus of elasticity greater than about 105 kg/m².

7. The method of claim 5 wherein said annular contact further comprises a swage limit (30) having a top surface (38) and said step of swaging further comprises swaging said conductive bump until said top surface of said swage limit contacts said die and wherein said swage limit has a height (40) as measured from said top surface of said substrate substantially equal to a height (36) of said conductive bump.

8. A method of providing an electrical connection between a testing board (10) and an electrical circuit disposed on a die (22), comprising the steps of:
providing an annular contact (16) having an opening (24) on either the board (10) or the die (22);
aligning a conductive bump (20) disposed on the opposing die or board, respectively, with said opening; and
swaging said conductive bump into said opening to provide said electrical connection by contacting the edge (26) of said opening.

9. The method of claim 8 wherein said annular contact further comprises a swage limit (30) having a top surface (38) and said step of swaging further comprises swaging said conductive bump until said top surface of said swage limit contacts said die.

10. The method of claim 9 wherein said opening of said annular contact comprises a first portion (32) having a first diameter corresponding to said swage limit and a second portion (34) having a second diameter corresponding to said conductive bump and wherein said first diameter is greater than said second diameter.

## Patentansprüche

1. Testplatine (10) zur Kontaktgebung einer elektronischen Einrichtung, die an einem Chip (22) angeordnet ist, wobei eine Vielzahl von leitfähigen Kontakthöckern (20) auf einer Oberfläche (21) dieses Chips angeordnet ist, umfassend:
• ein Trägermaterial (12)
• eine Signalschicht (14), die von diesem Trägermaterial getragen wird; und
gekennzeichnet durch einen ringförmigen Kontakt (16), der auf diesem Trägermaterial angeordnet und elektrisch leitend mit dieser Signalschicht verbunden ist, wobei dieser ringförmige Kontakt eine Öffnung (24) entsprechend zu einer aus dieser Vielzahl von leitfähigen Kontakthöckern hat, wodurch es diesem einen leitfähigen Kontakthöcker ermöglicht ist, in diese Öffnung angedrückt zu werden, um die Kante (26) dieser Öffnung zu kontaktieren.

2. Testplatine nach Anspruch 1, wobei dieser ringförmige Kontakt im wesentlichen rund ist und ein Duchmesser dieser Öffnung einem Durchmesser dieses einen aus dieser Vielzahl von leitfähigen Kontakthöckern entspricht und wobei dieser Durchmesser dieser Öffnung kleiner ist als dieser Durchmesser dieses einen aus dieser Vielzahl von leitfähigen Kontakthöckern.

3. Testplatine nach Anspruch 1, wobei dieser ringförmige Kontakt zumindestens mit einem Material beschichtet ist, das aus der Gruppe, die Palladium, Platin oder Rhodium enthält, ausgewählt ist.

4. Testplatine nach Anspruch 1, wobei dieser ringförmige Kontakt weiterhin eine Andrückbegrenzung (30) umfaßt, die eine obere Fläche (38) zur Kontaktierung dieses Chips aufweist.

5. Verfahren zum Testen einer elektronischen Einrichtung, die an einem Chip (22) angeordnet ist, wobei ein leitfähiger Kontakthöcker (20) an diesem Chip angeordnet ist, die folgenden Schritte umfassend:
• Bereitstellen einer Testplatine (10), die ein Trägermaterial (12) und einen ringförmigen Kontakt (16) aufweist, der über eine obere Fläche (18) dieses Trägermaterials hinausragt, wobei dieser ringförmige Kontakt eine Öffnung (24) entsprechend zu diesem leitfähigen Kontakthöcker aufweist; und
• Andrücken dieses leitfähigen Kontakthöckers, so daß sich ein Teil dieses Kontakthöckers in diese Öffnung erstreckt, um die Kante dieser Öffnung zu kontaktieren.

6. Verfahren nach Anspruch 5, wobei dieser leitfähige Kontakthöcker ein Modul mit einer Elastizität kleiner als etwa 28 kg/m² aufweist und dieser ringförmige Kontakt ein Modul mit einer Elastizität größer als etwa 105 kg/m² aufweist.

7. Verfahren nach Anspruch 5, wobei dieser ringförmige Kontakt weiterhin eine Andrückbegrenzung (30) enthält, die eine obere Fläche (38) aufweist und dieser Schritt des Andrückens weiterhin ein Andrücken dieses leitfähigen Kontakthöckers umfaßt, bis diese obere Fläche dieser Andrückbegrenzung diesen Chip kontaktiert, und wobei diese Andrückbegrenzung eine Höhe (40) aufweist, die gemessen von dieser oberen Fläche dieses Trägermaterials im wesentlichen einer Höhe (36) dieses leitfähigen Kontakthöckers gleicht.

8. Verfahren zur Bereitstellung einer elektrischen Verbindung zwischen einer Testplatine (10) und einer elektrischen Schaltung, die auf einem Chip (22) angeordnet ist, die folgenden Schritte umfassend:
• Bereitstellen eines ringförmigen Kontaktes (16), der eine Öffnung (24) entweder an der Platine (10) oder an dem Chip (22) aufweist;
• Ausrichten eines Kontakthöckers (20), der an dem gegenüberstehenden Chip beziehungsweise der Platine angeordnet ist, mit dieser Öffnung; und
• Andrücken dieses leitfähigen Kontakthöckers in diese Öffnung zur Bereitstellung dieser elektrischen Verbindung durch das Kontaktieren der Kante (26) dieser Öffnung.

9. Verfahren nach Anspruch 8, wobei dieser ringförmige Kontakt weiterhin eine Andrückbegrenzung (30) enthält, die eine obere Fläche (38) aufweist, und wobei dieser Schritt des Andrückens weiterhin ein Andrücken dieses leitfähigen Kontakthöckers umfaßt, bis diese obere Fläche dieser Andrückbegrenzung diesen Chip kontaktiert.

10. Verfahren nach Anspruch 9, wobei diese Öffnung dieses ringförmigen Kontaktes einen ersten Bereich (32) umfaßt, der einen ersten Durchmesser entsprechend zu dieser Andrückbegrenzung aufweist, und einen zweiten Bereich (34), der einen zweiten Durchmwesser entsprechend zu diesem leitfähigen Kontakthöcker aufweist, und wobei dieser erste Durchmesser größer als dieser zweite Durchmesser ist.

## Revendications

1. Carte de test (10) destinée à entrer en contact avec un dispositif électronique disposé sur une puce (22) où une pluralité de bossements conducteurs (20) sont disposés sur une surface (21) de ladite puce, comprenant :
un substrat (12) ;
une couche de signal (14) supportée par ledit substrat ; et caractérisée par un contact annulaire (16) disposé sur ledit substrat et connecté électriquement à ladite couche de signal, où ledit contact annulaire comporte une ouverture (24) correspondant à l'un de ladite pluralité de bossements conducteurs, ce qui permet audit bossement conducteur d'être reflué dans ladite ouverture de manière à entrer en contact avec le bord (26) de ladite ouverture.

2. Carte de test selon la revendication 1, dans laquelle ledit contact annulaire est sensiblement rond et un diamètre de ladite ouverture correspond à un diamètre dudit un de ladite pluralité de bossements conducteurs et dans laquelle ledit diamètre de ladite ouverture est inférieur audit diamètre dudit un de ladite pluralité de bossements conducteurs.

3. Carte de test selon la revendication 1, dans laquelle ledit contact annulaire est plaqué à l'aide d'au moins un matériau choisi parmi le groupe comprenant le palladium, le platine et le rhodium.

4. Carte de test selon la revendication 1, dans laquelle ledit contact annulaire comprend en outre une limite de refluage (30) comportant une surface supérieure (38) pour entrer en contact avec ladite puce.

5. Procédé de test d'un dispositif électronique disposé sur une puce (22), dans lequel un bossement conducteur (20) est disposé sur ladite puce, comprenant les étapes de :
constitution d'une carte de test (10) comportant un substrat (12) et un contact annulaire (16) faisant saillie depuis une surface supérieure (18) dudit substrat où ledit contact annulaire comporte une ouverture (24) correspondant audit bossement conducteur ; et
refluage dudit bossement conducteur de telle sorte qu'une partie dudit bossement conducteur s'étende à l'intérieur de ladite ouverture en entrant en contact avec le bord de ladite ouverture.

6. Procédé selon la revendication 5, dans lequel ledit bossement conducteur présente un module d'élasticité inférieur à environ 28 kg/m² et ledit contact annulaire présente un module d'élasticité supérieur à environ 105 kg/m².

7. Procédé selon la revendication 5, dans lequel ledit contact annulaire comprend en outre une limite de refluage (30) comportant une surface supérieure (38) et ladite étape de refluage comprend en outre le refluage dudit bossement conducteur jusqu'à ce que ladite surface supérieure de ladite limite de refluage entre en contact avec ladite puce et dans lequel ladite limite de refluage présente une hauteur (40) telle que mesurée depuis ladite surface supérieure dudit substrat sensiblement égale à une hauteur (36) dudit bossement conducteur.

8. Procédé de constitution d'une connexion électrique entre une carte de test (10) et un circuit électrique disposé sur une puce (22), comprenant les étapes de :
constitution d'un contact annulaire (16) comportant une ouverture (24) soit sur la carte (10), soit sur la puce (22) ;
alignement d'un bossement conducteur (20) disposé respectivement sur la puce ou la carte opposée avec ladite ouverture ; et
refluage dudit bossement conducteur dans ladite ouverture de manière à constituer ladite connexion électrique par une mise en contact avec le bord (26) de ladite ouverture.

9. Procédé selon la revendication 8, dans lequel ledit contact annulaire comprend en outre une limite de refluage (30) comportant une surface supérieure (38) et ladite étape de refluage comprend en outre le refluage dudit bossement conducteur jusqu'à ce que ladite surface supérieure de ladite limite de refluage entre en contact avec ladite puce.

10. Procédé selon la revendication 9, dans lequel ladite ouverture dudit contact annulaire comprend une première partie (32) présentant un premier diamètre correspondant à ladite limite de refluage et une seconde partie (34) présentant un second diamètre correspondant audit bossement conducteur et dans lequel ledit premier diamètre est supérieur audit second diamètre.
